# EUROPEAN PATENT APPLICATION

(11) **EP 4 571 190 A1**
(43) Date of publication of application: **18.06.2025**
(21) Application number: 24217321.9
(22) Date of filing: 04.12.2024
(51) Int. Cl.: F23N 5/08

(54) **MONITORING DEVICE, BURNING APPLIANCE AND SIGNAL AMPLIFICATION METHOD**

(30) Priority: 15.12.2023 GB 202319233
(71) Applicant: Bosch Thermotechnology Ltd (UK), Worcester, Worcestershire WR4 9SW (GB)
(72) Inventor: Batema, Hugo, 7418 BG Deventer, Overijssel (NL); Snijder, Ab, 8051 JH Hattem (NL)
(74) Representative: Bee, Joachim

(57) **Abstract**

A monitoring device, in particular flame monitoring device, with an optical sensor (10), in particular a UV sensor, for a monitoring of a flame (12), and with an amplifier electronics (14) unit comprising at least one operational amplifier (16) that is connected as a transimpedance amplifier (18) and is configured at least for an amplification of a sensor signal (20) outputted by the optical sensor (10) is already known.

It is proposed, that the amplifier electronics (14) unit is configured to amplify the sensor signal (20) in at least one first value range (22) by a first amplification factor (26) and in at least one second value range (24) by a second amplification factor (28).

## Description

### Prior art

A monitoring device, in particular flame monitoring device, with an optical sensor, in particular a UV sensor, for a monitoring of a flame, and with an amplifier electronics unit comprising at least one operational amplifier that is connected as a transimpedance amplifier and is configured at least for an amplification of a sensor signal outputted by the optical sensor is already known.

### Disclosure of the invention

The invention is based on a monitoring device, in particular flame monitoring device, with an optical sensor, in particular a UV sensor, for a monitoring of a flame, and with an amplifier electronics unit comprising at least one operational amplifier that is connected as a transimpedance amplifier and is configured at least for an amplification of a sensor signal outputted by the optical sensor.

It is proposed, that the amplifier electronics unit is configured to amplify the sensor signal in at least one first value range by a first amplification factor and in at least one second value range by a second amplification factor.

The monitoring device according to the invention can advantageously provide a construction with low costs, because in particular an entire operating range of the flame can be monitored with only one optical sensor and thus the use of further optical sensors can be omitted. Advantageously, a particularly high measurement accuracy can be provided, because all measuring ranges are provided with a matching amplification factor. Advantageously, a minor complexity can be provided with regard to a measurement signal evaluation, because in particular only one measurement signal has to be analysed and more complex autoranging control can be avoided. Advantageously, a high response speed can be provided, because in particular no range switch delay occurs.

Preferably, the monitoring device is configured to detect a flame, in particular a hydrogen flame or a natural gas, of an automatically operated burning appliance or an automatic burner control system. In particular, the monitoring device is configured to detect an electromagnetic radiation, preferably in a UV-range and/or in a visible range and/or in an infrared range. Preferably, the burning appliance is configured to burn gaseous or liquid fuels. It is also conceivable that the monitoring device is used to detect a glowing wire or an ambient brightness and/or a comparable electromagnetic radiation. It is conceivable that the monitoring device is part of the control system of the burning appliance or is used to regulate the flame/burning appliance. Preferably, the monitoring device is configured to convert a light intensity, in particular a wavelength range of the electromagnetic radiation emitted by the flame, into a proportional electrical voltage output signal. Preferably, the sensor signal is configured as an electric sensor signal, for example an electric current, which is at least substantially proportional to the light intensity of the flame. Preferably, the monitoring device comprises at least one housing, which is configured to protect and hold/fix the amplifier electronics unit. It is conceivable that the monitoring device comprises optical elements, for example optical waveguides and/or optical lenses and/or optical apertures or the similar. Preferably, the monitoring device comprises a control unit that is configured to analyze at least the signal outputted by the amplifier electronics. Preferably, the control unit comprises at least one analog-to-digital converter, which is configured to convert the analog sensor signal, in particular the amplified output voltage, into a digital signal. Preferably the monitoring electronics unit comprises an optical sensor which is configured as at least one photodiode. Preferably, the photodiode comprises at least one UV-sensitive measuring range. Alternatively, the optical sensor could also be an infrared sensor or a sensor with a wavelength range that appears reasonable to the person skilled in the art. Preferably, the optical sensor is configured to convert a light intensity at least of one range, preferably UV-range, of the electromagnetic radiation emitted by the flame into an electric current. In this context, "at least substantially" is to be understood in particular as meaning that a deviation from a specified value is in particular less than 25%, preferably less than 10% and particularly preferably less than 5% of the specified value.

Preferably, the monitoring electronics unit comprises at least one amplifier electronics unit, which is configured to convert the electric current generated by the optical sensor into an electric voltage signal. In particular, the amplifier electronics unit is configured to amplify the electric voltage signal. Preferably, the amplifier electronics unit comprises at least one operational amplifier, which is configured to convert the electric current into the electric voltage. Preferably, the operational amplifier is circuited as a transimpedance amplifier. Preferably, the amplifier electronics unit comprises at least one resistor, in particular several resistors, which is configured to amplify the voltage of the operational amplifier. Preferably, the amplifier electronics unit comprises at least one capacitor which is configured to suppress/eliminate noise.

Preferably, the first amplification factor is configured to amplify a weak sensor signal. For example, the sensor signal is weak at an early stage, in particular at switch-on of the flame. For example, the weak sensor signal is generated by a small light intensity of the flame. Preferably, the second amplification factor is configured to amplify a strong sensor signal. For example, the strong sensor signal is generated by a high light intensity of the flame. For example, the sensor signal is strong in a full power mode of the burning appliance, in particular the gas burner. Preferably, the at least first value range and/or the at least second value range are configured to set the amplification factor of the amplifier electronics unit. Preferably the first value range and the second value range change into each other. Preferably, the first value range comprises at least one upper limit, which is a part of the first value range. For example, the sensor signal is assigned to the second value range when the upper limit of the first value range is exceeded.

It is moreover proposed, that the first amplification factor is greater than the second amplification factor. Advantageously, a particularly high measurement accuracy can be provided, because all measuring ranges are provided with a matching amplification factor. Preferably, the second amplification factor is different from the first amplification factor. It is conceivable that the second amplification factor is greater than the first amplification factor. Preferably, the first amplification factor and the second amplification factor are at least substantially constant.

Furthermore it is proposed, that the amplifier electronics unit comprises at least one first amplifier unit and a second amplifier unit, which are switched with each other in parallel. Advantageously, a particularly high level of operation safety can be provided, because in particular the amplification factor is automatically set by the electronic circuit and does not have to be selected between the first and the second amplifier unit. Advantageously, a high degree of flexibility can be provided, because in particular the amplifier electronics unit comprises at least two different amplifier units. Preferably, the first amplifier unit comprises at least one first resistor and the second amplifier unit comprises at least one second resistor. Preferably, the first amplifier unit and the second amplifier unit comprise at least the first resistor. Preferably, the second amplification unit is arranged parallel to the first amplification unit. Preferably the second amplifier unit is designed as a feedback loop. Preferably, the first amplifier unit is configured to generate the first amplification factor in the first value range. Preferably, the second amplifier unit is configured to generate the second amplification factor in the second value range. An "amplification unit" is to be understood in particular as a circuit, preferably of at least two connections, of the operational amplifier, which is configured to at least amplify the signal. A "feedback loop" is in particular a circuit, which feeds back an electrical signal, particular an electric current, at least partially to itself.

It is moreover proposed, that the amplifier electronics unit comprises at least one first amplifier unit and at least one second amplifier unit, the second amplifier unit comprising at least one electronic switch, in particular a transistor, which is configured, if a cutoff voltage of the at least one electronic switch is exceeded, to connect the second amplifier unit in addition to the first amplifier unit. Advantageously, a high level of operation safety can be provided, because in particular the amplification factor is automatically set by the electronic circuit and does not have to be selected between the first and the second amplifier unit. Preferably, the electronic switch is designed to be switched as a function of voltage. Preferably, the electronic switch is designed to conduct an electric current when the cut-off voltage is exceeded. For example, the electronic switch is designed as a semiconductor component which conducts an electric current when the cutoff voltage is exceeded. Preferably, the electronic switch is designed to connect the second amplifier electronics unit to the first amplification unit when the cutoff voltage is exceeded.

Furthermore, it is proposed, that the cutoff voltage of the at least one electronic switch has a value of less than 500 mV, preferably at least substantially 260 mV. Advantageously, a particularly high performance can be provided, because in particular, due to the low cutoff voltage, a great amplification can be provided at a low sensor signal. In particular, the cutoff voltage is at least 50 mV, preferably 100 mV, and preferably 150 mV. For example, by designing the resistors, the circuit is designed with a value for the cutoff voltage of less than 500 mV and greater than 50 mV. It is conceivable that the person skilled in the art can select an electronic switch with a cutoff voltage out of the range.

It is moreover proposed, that the amplifier electronics unit comprises at least one temperature-dependent resistor, preferably an NTC resistor, which is configured to at least substantially compensate at least a temperature dependency of the cutoff voltage of the at least one electronic switch. Advantageously, a particularly high measuring accuracy can be provided, because in particular the temperature dependence of the limit value is compensated by the temperature-dependent resistor. Preferably, the temperature-dependent resistor is configured to hold the cutoff voltage of the electronic switch at least substantially constant. Alternatively, the temperature-dependent resistor could also be designed as a PTC resistor or a comparable electronic component for temperature compensation. In this context, "temperature compensation" is intended to be interpreted, in particular, a device which is configured to counteract a temperature effect and/or to eliminate the effects of a temperature change, for example on the limit voltage.

Furthermore it is proposed, that the temperature-dependent resistor is arranged at a VCC supply of the operational amplifier. Advantageously, a design with low complexity can be provided, because, in particular, an additional voltage source can be omitted due to the arrangement at the VCC supply. Preferably, the operational amplifier is configured to supply the temperature-dependent resistor with an electrical voltage, in particular for temperature compensation of the cut-off voltage. Preferably, the VCC supply (supply voltage) provides at least substantially the, in particular constant, electrical voltage for temperature compensation of the electronic switch. Alternatively, the temperature-dependent resistor could also be arranged on a similar power source, such as a battery or power supply. A "VCC supply" is to be understood in particular as a voltage supply of the operational amplifier and is configured as a constant voltage source.

Additionally, a burning appliance with at least one monitoring device is proposed. Advantageously a construction with low costs can be provided, because in particular an entire operating range of the flame can be monitored with only one optical sensor and thus the use of further optical sensors can be omitted. Advantageously, a particularly high measurement accuracy can be provided, because all measuring ranges are provided with a matching amplification factor. Advantageously, a minor complexity can be provided with regard to a measurement signal evaluation, because in particular only one measurement signal has to be analysed. Preferably, the burning appliance comprises at least one control and/or regulating unit which is configured to at least analyse an output voltage of the amplifier electronics unit. It is imaginable that the burning appliance comprises further electronic components, such as fuses and/or cable connections or the like, and/or optical components, such as mirrors and/or light wave guides or the like.

Furthermore, a signal amplification method for a monitoring device is proposed, wherein a luminous-intensity-dependent sensor signal, in particular a photodiode current of an optical sensor, is converted into a voltage and amplified by an operational amplifier that is connected as a transimpedance amplifier, wherein the sensor signal is amplified in at least one first value range by a first amplification factor and in at least one second value range by a second amplification factor. Advantageously, a particularly high measurement accuracy can be provided, because all measuring ranges are provided with a matching amplification factor. Preferably, the light intensity of the flame is converted into a photodiode current by the optical sensor. Preferably, the sensor signal in the second value range is amplified with a greater amplification factor than the sensor signal in the first value range.

Additionally it is proposed, that a second amplifier unit is additionally connected via at least one electronic switch, in particular a transistor, at least depending on the sensor signal of a first amplifier unit, if a cutoff voltage of the at least one electronic switch is exceeded. Advantageously, a low complexity can be provided, because in particular the amplification factor is automatically set by the electronic circuit and does not have to be selected between the first and the second amplifier unit. Preferably, the electronic switch is switched automatically, when the cutoff voltage is exceeded. Preferably, the second amplifier unit is automatically connected to the first amplifier unit when the cutoff voltage is exceeded. Preferably, a weak sensor signal, especially in the first value range, is amplified with the first amplifier unit and a strong sensor signal, especially in the second value range, is amplified with the second amplifier unit. Preferably, the sensor signal is amplified in the first amplifier unit with the first amplification factor and in the second amplifier unit with the second amplification factor, whereby the sensor signal is amplified in the second amplifier unit with a greater amplification factor than in the first amplifier unit.

Furthermore it is proposed, that the cutoff voltage of the electronic switch is compensated in terms of temperature by a temperature-dependent resistor, preferably by an NTC resistor. Advantageously, a particularly high measuring accuracy can be provided, because in particular the temperature dependence of the limit value is compensated by the temperature-dependent resistor. Preferably, the cut-off voltage is maintained constant by the temperature-dependent resistor. Preferably, the temperature-dependent resistor is fed from the VCC supply of the operational amplifier. Preferably, the temperature-dependent resistor is supplied by the supply voltage (VCC supply) of the operational amplifier.

The monitoring device according to the invention, the burning appliance according to the invention and the signal amplification method according to the invention are not intended to be limited to the application and embodiment described above. In particular, the monitoring device according to the invention, the burning appliance according to the invention and the signal amplification method according to the invention may have a number of individual elements, components and units as well as process steps deviating from a number mentioned herein in order to fulfill a mode of operation described herein. In addition, for the ranges of values specified in this disclosure, values lying within the specified limits are also to be considered disclosed and usable as desired.

### Drawings

Further advantages may be gathered from the following description of the drawings. In the drawings an exemplary embodiment of the invention is shown. The drawings, the description and the claims comprise a plurality of features in combination. The person skilled in the art will expediently also consider the features individually and will bring them together in further purposeful combinations.

The drawings show:
- Fig. 1: a schematic electronic circuit of the monitoring device with a first and a second amplifier unit,
- Fig. 2: a schematic flowchart of a signal amplification method and
- Fig. 3: a schematic diagram of an output signal as a function of the sensor signal.

### Description of the exemplary embodiment

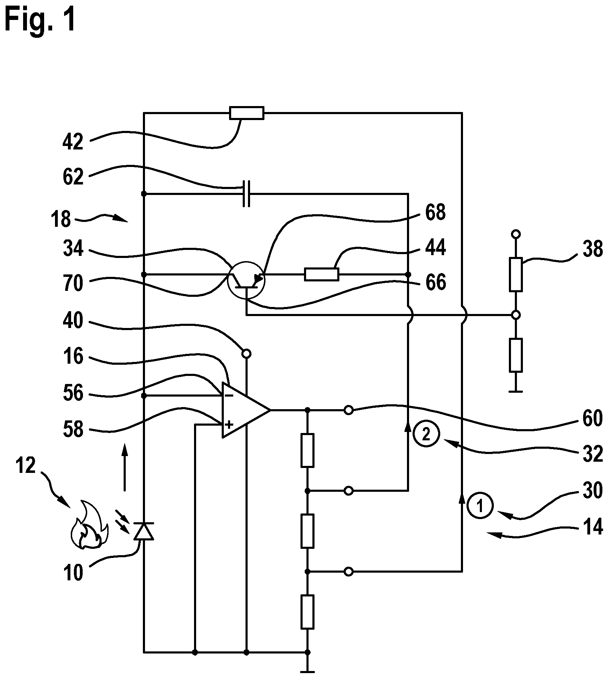

The figure 1 shows a burning appliance. The burning appliance comprises a flame 12. The flame 12 is embodied as a hydrogen flame 12. The flame 12 could also be configured as a natural gas flame or oil flame or a comparable flame 12. The burning appliance comprises one monitoring device. The monitoring device is configured as a flame monitoring device. The monitoring device comprises an optical sensor 10. The optical sensor 10 is configured as an UV sensor. The optical sensor 10 is configured as a photodiode. The optical sensor 10 is configured to monitor the flame 12. The flame 12 comprises a light intensity. The light intensity is configured as the intensity of an electromagnetic wavelength of the flame 12. The optical sensor 10 converts the light intensity/electromagnetic wavelength into an electric current. The optical sensor 10 could also be configured as a comparable optical sensor 10 for a wavelength range in the visible light or in the infrared range. The optical sensor 10 is configured to generate a sensor signal 20. The optical sensor 10 is configured to generate an electric current depending on the light intensity of the flame 12.

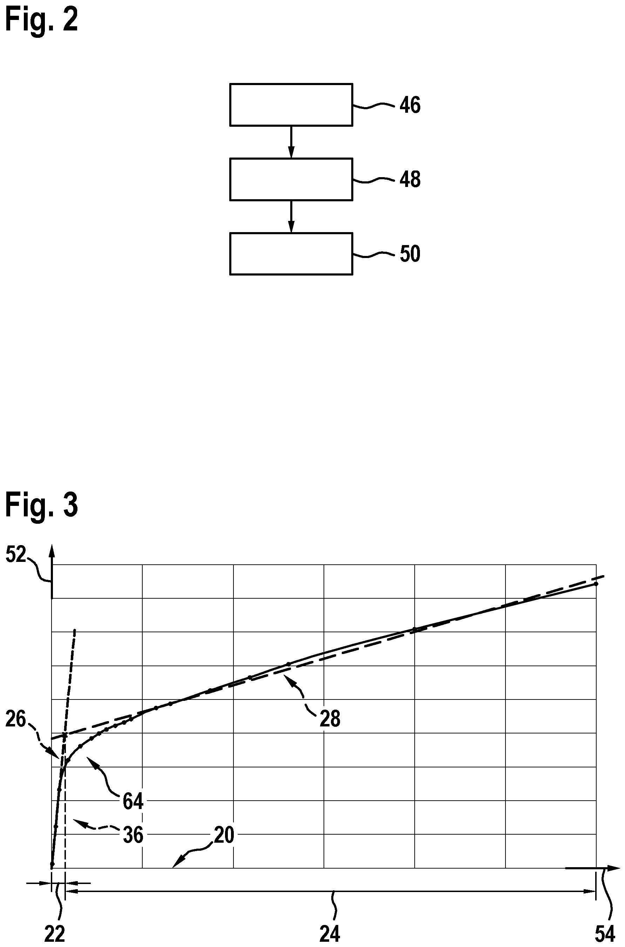

The monitoring device comprises an amplifier electronics unit 14. The amplifier electronics unit 14 comprises one operational amplifier 16. The operational amplifier 16 comprises an inverting input 56. The operational amplifier 16 comprises a non-inverting 58 input. The inverting input 56 and the non-inverting input 58 are connected to the optical sensor 10. The operational amplifier 16 has an output 60. The operational amplifier 16 is connected as a transimpedance amplifier 18. The transimpedance amplifier 18 is configured for an amplification of the sensor signal 20 outputted by the optical sensor 10 (see fig. 3). The transimpedance amplifier 18 is configured to convert the electric current, generated by the optical sensor 10, into an electrical voltage and is configured to amplify the converted electric voltage. The amplifier electronics unit 14 is configured to amplify the sensor signal 20 in one first value range 22 by a first amplification factor 26 (see fig. 3). The amplifier electronics unit 14 is configured to amplify the sensor signal 20 in one second value range 24 by a second amplification factor 28 (see fig. 3). The first amplification factor 26 is greater than the second amplification factor 28. The first value range 22 changes to the second value range 24.

The amplifier electronics unit 14 comprises at least one first amplifier unit 30. The first amplifier unit 30 is connected to the inverting input 56 and the output 60 of the operational amplifier 16. The first amplifier unit 30 comprises a first resistor 42. In this design the first resistor 42 has 10 GOhm. The first resistor 42 comprises three supplementary resistors, which are connected in series. Depending on the circuit, in particular the resistances of other resistors of the circuit, the first resistor 42 could also be larger or smaller than 10 GOhm. The first resistor 42 is configured as an equivalent resistance, which consists of the three resistors. The first resistor 42 could also be configured from a multiple number of resistors. In an alternative embodiment, the first resistor 42 could also have a resistance of for example 50 MOhm. This alternative first resistor 42 with the resistance of 50 MOhm could be configured to perform like a 7,5 GOhm resistor, if the output 60 voltage is adjusted for example by a factor of 150 provided by other resistors of the circuit. The first amplifier unit 30 is configured as a feedback loop. The amplifier electronics unit 14 comprises one second amplifier unit 32. The second amplifier unit 32 comprises a second resistor 44. The second amplifier unit 32 is connected to the inverting input 56 of the operational amplifier 16 and to the output 60. The second amplifier unit 32 is arranged in parallel to the first amplifier unit 30. The second amplifier unit 32 is configured as a feedback loop. The amplifier electronics unit 14 comprises a resistor divider configured to generate the first amplifier unit 30 and the second amplifier unit 32 at the output 60. The first amplifier unit 30 and the second amplifier unit 32 are connected to each other to provide the second amplifier factor 28. The second amplifier unit 32 comprises one electronic switch 34. The electronic switch 34 is configured as a transistor. The transistor comprises a base junction 66, an emitter 68 and a collector 70. The emitter 68 and the collector 70 are connected to the inverting input 56 of the operational amplifier 16 and the output 60 of the operational amplifier 16. The electronic switch 34 provides a cutoff voltage 36. The electronic switch 34 is configured to connect the second amplifier unit 32 in addition to the first amplifier unit 30, if the cutoff voltage 36 is exceeded. The cutoff voltage 36 of the one electronic switch 34 has a value of 260 mV. The cutoff voltage 36 depends on the design of the electronic switch 34. The selected cutoff voltage 36 of the electronic switch 34 depends on the design of the circuit and the sensor signal 20. The circuit is designed in a manner that the value for the cutoff voltage 36 is less than 500 mV and greater than 50 mV. However, if necessary, the person skilled in the art can select an electronic switch 34 with a cutoff voltage 36 out of the range. The amplifier electronics unit 14 comprises one capacitor 62 which is configured to suppress/eliminate noise. The capacitor 62 is connected in parallel to the first amplifier unit 30 and the second amplifier unit 32.

The amplifier electronics unit 14 comprises one temperature-dependent resistor 38. The temperature dependent resistor 38 is connected to the base junction 68 of the transistor. The temperature-dependent resistor 38 is configured as an NTC resistor. The temperature-dependent resistor 38 could also be configured as a PTC resistor or an equivalent temperature-dependent resistor. The temperature-dependent resistor 38 is configured to compensate a temperature dependency of the cutoff voltage 36 of the electronic switch 34. The temperature-dependent resistor 38 is arranged at a VCC supply (supply voltage) 40 of the operational amplifier 16. Alternatively, the temperature-dependent resistor 38 could also be arranged on an equivalent voltage source, such as a battery or a power supply.

The figure 2 shows a schematic flowchart of a signal amplification method for the monitoring device.

In a method step 46 the photodiode current of an optical sensor 10 is converted into a voltage and amplified by the operational amplifier 16 that is connected as a transimpedance amplifier 18. The sensor signal 20 is amplified in one first value range 22 by a first amplification factor 26 and in one second value 24 range by a second amplification factor 28. The amplification of the sensor signal 20 is determined by a total resistance between the inverting input 56 of the operational amplifier 16 and the output 60 of the operational amplifier 16. The total resistance is determined by calculating the individual resistances to an equivalent resistance. Noise is eliminated by the capacitor 62 connected to the inverting input 56 and the output 60 and/or in parallel to the second resistor 44.

In a method step 48 the second amplifier unit 32 is additionally connected to the first amplifier unit 32 via the electronic switch 34 depending on the sensor signal 20 of a first amplifier unit 30, if a cutoff voltage 36 of the electronic switch 34 is exceeded. The second amplifier unit 32 is connected to the first amplifier stage 30, when the cutoff voltage 36 is exceeded. When the cutoff voltage 36 is exceeded, the electronic switch 34 is activated. By activating the electronic switch 34, the sensor signal 20 is amplified with the second amplification factor 28. The first/second amplification factor 26, 28 is switched abruptly to the second/first amplification 28, 26 factor.

In a method step 50 the cutoff voltage 36 of the electronic switch 34 is compensated in terms of temperature by a temperature-dependent resistor 38, preferably by an NTC resistor. The temperature-dependent resistor 38 is used to generate a temperature-dependent voltage, which is used to control the cutoff voltage 36 of the electronic switch 34. The cutoff voltage 36 is maintained constant by the temperature compensation by means of the temperature-dependent resistor 38. The temperature-dependent resistor 38 is supplied by the VCC supply (supply voltage) 40 of the operational amplifier 16.

Figure 3 shows a signal strength diagram. The signal strength diagram comprises an ordinate 52. The signal strength diagram comprises an abscissa 54. On the ordinate 52, the output signal of the transimpedance amplifier 18 against a ground is plotted as an electrical voltage. On the abscissa 54 the light intensity of the flame 12 is plotted. The signal strength diagram comprises a first value range 22 on the abscissa 54. The first value range 22 comprises the first amplification factor 26. The signal strength diagram comprises the second value range 24 on the abscissa 54. The second value range 24 comprises the second amplification factor 28. The signal strength diagram shows a knee threshold 64. The knee threshold 64 shows the threshold from the first value range 22 to the second value range 24. This knee threshold 64 as the threshold between the first amplification factor 26 and the second amplification factor 28 is temperature dependent. However, this temperature dependence is eliminated by the temperature compensation with the temperature-dependent resistor. The temperature-dependent resistor is configured to compensate the temperature dependence of the electronic switch, which is about -2mV/°C.

## Claims

1. Monitoring device, in particular flame monitoring device, with an optical sensor (10), in particular a UV sensor, for a monitoring of a flame (12), and with an amplifier electronics unit (14) comprising at least one operational amplifier (16) that is connected as a transimpedance amplifier (18) and is configured at least for an amplification of a sensor signal (20) outputted by the optical sensor (10), **characterized in that** the amplifier electronics (14) unit is configured to amplify the sensor signal (20) in at least one first value range (22) by a first amplification factor (26) and in at least one second value range (24) by a second amplification factor (28).

2. Monitoring device according to claim 1, **characterized in that** the first amplification factor (26) is greater than the second amplification factor (28).

3. Monitoring device according to claim 1 or 2, **characterized in that** the amplifier unit (14) comprises at least one first amplifier unit (30) and a second amplifier unit (32), which are switched with each other in parallel.

4. Monitoring device according to one of the preceding claims, **characterized in that** the amplifier electronics unit (14) comprises at least one first amplifier unit (30) and at least one second amplifier unit (32), the second amplifier unit (32) comprising at least one electronic switch (34), in particular a transistor, which is configured, if a cutoff voltage (36) of the at least one electronic switch (34) is exceeded, to connect the second amplifier unit (32) in addition to the first amplifier unit (30).

5. Monitoring device according to claim 4, **characterized in that** the cutoff voltage (36) of the at least one electronic switch (34) has a value of less than 500 mV, preferentially at least substantially 260 mV.

6. Monitoring device according to one of claims 4 or 5, **characterized in that** the amplifier electronics (14) unit comprises at least one temperature-dependent resistor (38), preferably an NTC resistor, which is configured to at least substantially compensate at least a temperature dependency of the cutoff voltage (36) of the at least one electronic switch (34).

7. Monitoring device according to claim 6, **characterized in that** the temperature-dependent resistor (38) is arranged at a VCC supply (40) of the operational amplifier (16).

8. Burning appliance with at least one monitoring device according to one of claims 1 to 7.

9. Signal amplification method for a monitoring device, in particular according to one of claims 1 to 8, by which a luminous-intensity-dependent sensor signal (20), in particular a photodiode current of an optical sensor (10), is converted into a voltage and amplified by an operational amplifier (16) that is connected as a transimpedance amplifier (18), **characterized in that** the sensor signal (20) is amplified in at least one first value range (22) by a first amplification factor (26) and in at least one second value range (24) by a second amplification factor (28).

10. Signal amplification method according to claim 9, **characterized in that** a second amplifier unit (32) is additionally connected via at least one electronic switch (34), in particular a transistor, at least depending on the sensor signal (20) of a first amplifier unit (30), if a cutoff voltage (36) of the at least one electronic switch (34) is exceeded.

11. Signal amplification method according to claim 9 or 10, **characterized in that** a cutoff voltage (36) of the electronic switch (34) is compensated in terms of temperature by a temperature-dependent resistor (38), preferably by an NTC resistor.
